# EUROPEAN PATENT APPLICATION

(11) **EP 3 690 496 A1**
(43) Date of publication of application: **05.08.2020**
(21) Application number: 18860218.9
(22) Date of filing: 11.09.2018
(51) Int. Cl.: G02B 5/20, C09K 11/06, C09K 11/08, C09K 11/56, C09K 11/70, F21V 9/08, H01L 33/50, F21W 103/10, F21Y 115/10, F21Y 115/30

(54) **WAVELENGTH CONVERSION MEMBER AND LIGHT SOURCE**

(30) Priority: 28.09.2017 JP 2017188021
(71) Applicant: Panasonic Intellectual Property Management Co., Ltd., Osaka-shi, Osaka 540-6207 (JP)
(72) Inventor: NAGASAKI, Yoshihisa, Osaka-shi, Osaka 540-6207 (JP); OHBAYASHI, Takashi, Osaka-shi, Osaka 540-6207 (JP); HAMADA, Takahiro, Osaka-shi, Osaka 540-6207 (JP); SUGIO, Yukihiko, Osaka-shi, Osaka 540-6207 (JP)
(74) Representative: Müller-Boré & Partner Patentanwälte PartG mbB
(86) International application number: PCT/JP2018/033523
(87) International publication number: WO 2019/065193

(57) **Abstract**

Provided is a wavelength conversion member having excellent heat dissipation properties. A wavelength conversion member according to the present disclosure includes wavelength conversion particles each including a fluorescent substance and a first matrix surrounding the fluorescent substance; and a second matrix having a thermal conductivity higher than a thermal conductivity of the first matrix and surrounding the wavelength conversion particles. The fluorescent substance is, for example, at least one selected from the group consisting of a fluorescent substance containing a quantum dot, a fluorescent substance containing a metal complex, and an organic fluorescent substance. The first matrix includes, for example, at least one selected from the group consisting of a resin and glass. The second matrix includes, for example, an inorganic crystal. The inorganic crystal is, for example, a zinc oxide crystal.

## Description

### TECHNICAL FIELD

The present disclosure relates to a wavelength conversion member and a light source.

### BACKGROUND ART

Recently, a light source is being developed that includes a light-emitting element and a wavelength conversion member. The wavelength conversion member includes a fluorescent substance embedded in a matrix. The light-emitting element irradiates the fluorescent substance with light serving as excitation light, and the fluorescent substance emits light having a wavelength longer than a wavelength of the excitation light. In this type of light source, an increase in luminance and output of light is being attempted.

Patent Literature (PTL) 1 discloses a wavelength conversion member that includes a fluorescent substance containing a quantum dot. PTL 2 discloses a light-emitting medium including an organic fluorescent substance as the fluorescent substance. In PTLS 1 and 2, the fluorescent substance is dispersed in a dispersing medium such as a liquid medium or an epoxy resin.

PTL 3 discloses a matrix formed of a ZnO polycrystal in a c-axis orientation.

Solution growth is disclosed in, for example, PTL 4.

### Citation List

### Patent Literatures

PTL 1: Unexamined Japanese Patent Publication No. 2010-61098
PTL 2: Unexamined Japanese Patent Publication No. 2008-182197
PTL 3: International Publication No. 2013/172025
PTL 4: Unexamined Japanese Patent Publication No. 2004-315342

### SUMMARY OF THE INVENTION

The wavelength conversion member in PTL 1 and the light-emitting medium in PTL 2 are still to be improved from a viewpoint of heat dissipation properties.

An object of the present disclosure is to provide a wavelength conversion member having excellent heat dissipation properties.

That is, the present disclosure provides a wavelength conversion member that includes wavelength conversion particles each including a fluorescent substance and a first matrix surrounding the fluorescent substance; and a second matrix having a thermal conductivity higher than a thermal conductivity of the first matrix and surrounding the wavelength conversion particles.

A technique of the present disclosure is capable of providing a wavelength conversion member having excellent heat dissipation properties.

### BRIEF DESCRIPTION OF DRAWINGS

FIG. 1 is a schematic sectional view of a wavelength conversion member according to one exemplary embodiment of the present disclosure.
FIG. 2 is a sectional view of a wavelength conversion particle illustrated in FIG. 1.
FIG. 3 is a sectional view of a quantum dot.
FIG. 4 is a sectional view of a wavelength conversion particle of a modified example of the present disclosure.
FIG. 5 is a schematic sectional view of a reflection-type light source including the wavelength conversion member according to the present disclosure.
FIG. 6 is a schematic sectional view of a transmission-type light source including the wavelength conversion member according to the present disclosure.
FIG. 7 is a schematic sectional view of another transmission-type light source including the wavelength conversion member according to the present disclosure.
FIG. 8 is a schematic configuration view of a lighting device including the light source according to the present disclosure.

### DESCRIPTION OF EMBODIMENTS

### (Knowledge underlying the present disclosure)

When the wavelength conversion member in PTL 1 or the light-emitting medium in PTL 2 are used, a temperature of a fluorescent substance is sometimes greatly raised. When the temperature of the fluorescent substance is greatly raised, light emission efficiency of the fluorescent substance is decreased. When a fluorescent substance containing a quantum dot is used, the great rise in the temperature of the fluorescent substance also gives a problem of burning off a ligand coordinated with the quantum dot.

Zinc oxide (ZnO) is an inorganic material having a refractive index close to refractive indexes of many fluorescent substances and having excellent translucency and high thermal conductive properties. Therefore, use of zinc oxide as a matrix material enables suppression of light scattering at an interface between a fluorescent substance and a ZnO matrix, so that high optical output is achieved. The matrix including zinc oxide can be formed by, for example, crystal growth of zinc oxide. For the crystal growth of zinc oxide, solution growth is usable that is performed with a solution containing a Zn ion. The fluorescent substance, however, is sometimes deactivated by being brought into contact with the solution for crystal growth.

A wavelength conversion member according to a first aspect of the present disclosure includes wavelength conversion particles each including a fluorescent substance and a first matrix surrounding the fluorescent substance; and a second matrix having a thermal conductivity higher than a thermal conductivity of the first matrix and surrounding the wavelength conversion particles.

According to the first aspect, the second matrix has a thermal conductivity higher than the thermal conductivity of the first matrix. Therefore, the wavelength conversion member has excellent heat dissipation properties.

In a second aspect of the present disclosure, the fluorescent substance of the wavelength conversion member according to the first aspect is, for example, at least one selected from the group consisting of a fluorescent substance containing a quantum dot, a fluorescent substance containing a metal complex, and an organic fluorescent substance. According to the second aspect, the wavelength conversion member is capable of giving light having excellent monochromaticity or light having excellent color rendering properties.

In a third aspect of the present disclosure, the first matrix of the wavelength conversion member according to the first or second aspect includes, for example, at least one selected from the group consisting of a resin and glass. According to the third aspect, the deactivation of the fluorescent substance is suppressed. That is, the fluorescent substance in each of the wavelength conversion particles is stabilized. Therefore, the fluorescent substance is capable of easily maintaining light emission characteristics.

In a fourth aspect of the present disclosure, the second matrix of the wavelength conversion member according to any one of the first to third aspects includes, for example, an inorganic crystal. According to the fourth aspect, the wavelength conversion member has excellent heat dissipation properties.

In a fifth aspect of the present disclosure, the inorganic crystal of the wavelength conversion member according to the fourth aspect is, for example, a zinc oxide crystal. According to the fifth aspect, the wavelength conversion member has excellent heat dissipation properties.

In a sixth aspect of the present disclosure, the zinc oxide crystal of the wavelength conversion member according to the fifth aspect is, for example, a zinc oxide polycrystal in a c-axis orientation. According to the sixth aspect, the wavelength conversion member has excellent heat dissipation properties.

In a seventh aspect of the present disclosure, the wavelength conversion particles of the wavelength conversion member according to any one of the first to sixth aspects have an average particle size ranging from 0.1 µm to 10 µm, inclusive. According to the seventh aspect, the wavelength conversion member has excellent heat dissipation properties.

In an eighth aspect of the present disclosure, the wavelength conversion particles of the wavelength conversion member according to any one of the first to seventh aspects each further include a protective layer covering the first matrix. According to the eighth aspect, the deactivation of the fluorescent substance is suppressed. That is, the fluorescent substance in each of the wavelength conversion particles is stabilized. Therefore, the fluorescent substance is capable of easily maintaining light emission characteristics.

A light source according to a ninth aspect of the present disclosure includes a light-emitting element and the wavelength conversion member according to any one of the first to eighth aspect, the wavelength conversion member being disposed on an optical path of light emitted from the light-emitting element.

According to the ninth aspect, the wavelength conversion member has excellent heat dissipation properties. Therefore, the light source having aimed optical characteristics can easily be provided.

Hereinafter, exemplary embodiments of the present disclosure are described with reference to drawings. The present disclosure is not limited to the following exemplary embodiments.

### (Exemplary embodiments of wavelength conversion member)

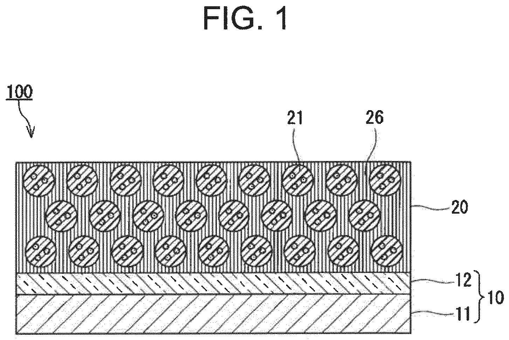

As illustrated in FIG. 1, wavelength conversion member 100 includes substrate 10 and wavelength conversion layer 20. Substrate 10 supports wavelength conversion layer 20. Wavelength conversion layer 20 is disposed on substrate 10. Wavelength conversion layer 20 includes second matrix 26 and wavelength conversion particle 21. Second matrix 26 is present among a plurality of wavelength conversion particles 21. Wavelength conversion particles 21 are embedded in second matrix 26. In other words, wavelength conversion particles 21 are dispersed in second matrix 26. Wavelength conversion particles 21 are surrounded by second matrix 26.

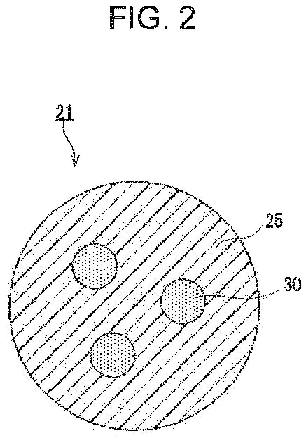

As illustrated in FIG. 2, wavelength conversion particle 21 includes first matrix 25 and fluorescent substance 30. First matrix 25 is present among a plurality of particles of fluorescent substance 30. Fluorescent substance 30 is embedded in first matrix 25. In other words, fluorescent substance 30 is dispersed in first matrix 25. Fluorescent substance 30 is surrounded by first matrix 25. Fluorescent substance 30 may be dissolved in first matrix 25.

Wavelength conversion member 100 that is irradiated with excitation light having a first wavelength band converts a part of the excitation light into light having a second wavelength band and emits the converted light. Wavelength conversion member 100 emits light having a wavelength longer than a wavelength of the excitation light. The second wavelength band is a band different from the first wavelength band. A part of the second wavelength band, however, may overlap the first wavelength band. The light emitted from wavelength conversion member 100 may include not only light emitted from fluorescent substance 30 but also the very excitation light.

Substrate 10 includes substrate main body 11 and thin film 12. Substrate 10 has, for example, a thickness larger than a thickness of wavelength conversion layer 20. Substrate main body 11 is made of at least one material selected from the group consisting of sapphire (Al₂O₃), gallium nitride (GaN), aluminum nitride (AlN), silicon, aluminum, glass, quartz (SiO₂), silicon carbide (SiC), and zinc oxide. Substrate main body 11 has translucency to, for example, the excitation light and the light emitted from fluorescent substance 30. Such a substrate main body allows wavelength conversion member 100 to be suitably used in a transmission-type light source. Substrate 10 having no translucency allows wavelength conversion member 100 to be used in a reflection-type light source. Substrate main body 11 may include a mirror-polished surface.

A surface of substrate main body 11 may be covered with an antireflection film, a dichroic mirror, a metal reflective film, an enhanced reflection film, a protective film, or the like. The antireflection film is a film for preventing reflection of the excitation light. The dichroic mirror can be formed of a dielectric multilayer film. The metal reflective film is a film for reflecting light and is made of a metal material such as silver or aluminum. The enhanced reflection film can be formed of a dielectric multilayer film. The protective film can be a film for physically or chemically protecting these films.

Thin film 12 functions as a ground layer for forming wavelength conversion layer 20. When second matrix 26 of wavelength conversion layer 20 is crystalline, thin film 12 functions as a seed crystal in a crystal growth process of second matrix 26. That is, thin film 12 is a monocrystalline thin film or a polycrystalline thin film. When second matrix 26 is formed of a ZnO monocrystal or a ZnO polycrystal, thin film 12 can be a ZnO monocrystalline thin film or a ZnO polycrystalline thin film. Thin film 12, however, need not be disposed when substrate main body 11 is capable of exerting a function as the seed crystal. For example, substrate main body 11 formed of crystalline GaN or crystalline ZnO enables second matrix 26 formed of crystalline ZnO to be directly formed on substrate main body 11.

Wavelength conversion layer 20 includes wavelength conversion particles 21 dispersed in second matrix 26. In FIG. 1, wavelength conversion particles 21 are separated from each other. Wavelength conversion particles 21, however, may be in contact with each other. Wavelength conversion particles 21 may be stacked like a stone wall.

Wavelength conversion particle 21 includes fluorescent substance 30 dispersed in first matrix 25. In FIG. 2, particles of fluorescent substance 30 are separated from each other. The particles of fluorescent substance 30, however, may be in contact with each other.

Fluorescent substance 30 receives the excitation light and emits fluorescence. Fluorescent substance 30 is, for example, at least one selected from the group consisting of an inorganic fluorescent substance and an organic fluorescent substance. The inorganic fluorescent substance is, for example, at least one selected from the group consisting of a fluorescent substance containing a quantum dot and a fluorescent substance containing a metal complex. Fluorescent substance 30 is typically a fluorescent substance containing a quantum dot.

The fluorescent substance containing a quantum dot may be formed of, for example, one quantum dot. The quantum dot is a particle containing a semiconductor crystal. The quantum dot has a nano-size particle size (particle diameter). Therefore, the quantum dot is capable of emitting light of fluorescence due to a quantum size effect.

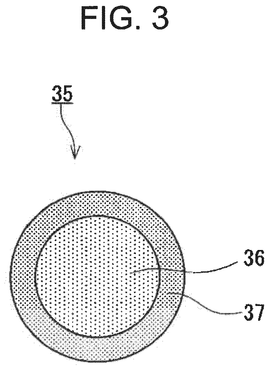

As illustrated in FIG. 3, quantum dot 35 includes, for example, core 36 and shell 37. Shell 37 covers core 36. Shell 37 may cover an entire surface of core 36. Shell 37 is in contact with core 36. Core 36 has a composition different from a composition of shell 37. Core 36 has a shape of, for example, a sphere.

Materials for core 36 and shell 37 each contain, for example, at least one selected from the group consisting of a group II-VI compound semiconductor, a group III-V compound semiconductor, and a group IV-VI compound semiconductor. The materials for core 36 and shell 37 may each contain Si.

The group II-VI compound semiconductor includes, for example, at least one selected from the group consisting of CdS, CdSe, CdTe, ZnS, ZnSe, ZnTe, ZnO, HgS, HgSe, HgTe, CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, CdZnSeS, CdZnSeTe, CdZnSTe, CdHgSeS, CdHgSeTe, CdHgSTe, HgZnSeS, HgZnSeTe, and HgZnSTe.

The group III-V compound semiconductor includes, for example, at least one selected from the group consisting of GaN, GaP, GaAs, GaSb, AlN, AlGaN, AlP, AlAs, AlSb, InN, InP, InAs, InSb, InGaN, GaNP, GaNAs, GaNSb, GaPAs, GaPSb, AlNP, AlNAs, AlNSb, AlPAs, AlPSb, InNP, InNAs, InNSb, InPAs, InPSb, GaAlNP, GaAlNAs, GaAlNSb, GaAlPAs, GaAlPSb, GaInNP, GaInNAs, GaInNSb, GaInPAs, InAlNP, InAlNAs, InAlNSb, InAlPAs, and InAlPSb.

The group IV-VI compound semiconductor includes, for example, SbTe.

The material for core 36 of quantum dot 35 contains, for example, InP. The material for shell 37 of quantum dot 35 contains, for example, ZnS.

Quantum dot 35 may be coordinated with a ligand. The ligand may be coordinated with, for example, a surface of shell 37. Quantum dots 35 each coordinated with the ligand have high dispersibility. The ligand includes, for example, a hydrocarbon compound. The hydrocarbon compound has a functional group. The hydrocarbon compound contains, for example, a straight or branched aliphatic group. The hydrocarbon compound may have a number of carbon atoms ranging from 2 to 30 or from 4 to 20. The functional group includes, for example, at least one selected from the group consisting of a carboxyl group, an amino group, an amide group, a nitrile group, a hydroxyl group, an ether group, a carbonyl group, a sulfonyl group, and a phosphonyl group. The hydrocarbon compound may further contain at least one selected from the group consisting of a halogen group, a halogenated alkyl group, an aromatic group, and an alkenyl group.

The hydrocarbon compound includes, for example, at least one selected from the group consisting of trioctylphosphinoxide (tri-n-octylphosphine oxide: TOPO) and trioctylphosphine (tri-n-octylphosphine: TOP).

Quantum dots 35 have an average particle size smaller than an average particle size of wavelength conversion particles 21. Quantum dots 35 may have an average particle size ranging from 1 nm to 1000 nm or from 2 nm to 100 nm. Quantum dots 35 may have an average particle size of less than or equal to 20 nm. The average particle size of quantum dots 35 can be determined by, for example, a following method. First, a section of wavelength conversion particle 21 is observed with a transmission electron microscope. In an obtained electron microscopic image, an area of specific quantum dot 35 is calculated by image processing. A diameter of a circle having a same area as the calculated area is regarded as a particle size (particle diameter) of specific quantum dot 35. Particle sizes of a certain number of quantum dots 35 (for example, 50 quantum dots) are each calculated and an average value of the calculated values is regarded as the average particle size of quantum dots 35. The section of wavelength conversion particle 21 can be exposed by a method such as a focused ion beam (FIB) method. In the present disclosure, a shape of quantum dot 35 is not limited. The shape of quantum dot 35 is, for example, spherical. In the present disclosure, the method for measuring the average particle size is not limited to the method described above.

The material for quantum dot 35, the average particle size of quantum dots 35, and a particle size of core 36 included in quantum dot 35 are selected according to chromaticity of light to be emitted from wavelength conversion member 100. For example, when core 36 of quantum dot 35 contains InP, shell 37 contains ZnS, and core 36 has a particle size (particle diameter) ranging from 1 nm to 20 nm, quantum dot 35 is capable of emitting red or green light. In detail, when core 36 has a particle size ranging from 6 nm to 10 nm, quantum dot 35 is capable of emitting red light. When core 36 has a particle size ranging from 4 nm to 8 nm, quantum dot 35 is capable of emitting green light. The light emitted from quantum dot 35 has excellent monochromaticity. When fluorescent substance 30 is a fluorescent substance containing quantum dot 35, light having excellent color rendering properties can also be obtained by wavelength conversion member 100.

The fluorescent substance containing a metal complex is formed of, for example, one metal complex. The metal complex contains a metal atom and a ligand. The ligand is coordinated with the metal atom. The metal atom is not particularly limited as long as the metal atom functions as a light emission center. The metal atom includes, for example, at least one selected from the group consisting of Fe, Cu, Zn, Al, and Au. The metal atom may include a rare earth element. The rare earth element includes, for example, at least one selected from the group consisting of Gd, Yb, Y, Eu, Tb, Nd, Er, Sm Dy, and Ce. When the metal atom includes a rare earth element, a wavelength of light absorbed in the metal complex is greatly different from a wavelength of light emitted from the metal complex. Therefore, the light emitted from the metal complex is not easily absorbed in another metal complex. This phenomenon enables wavelength conversion member 100 to achieve high quantum efficiency. In the metal complex, the metal atom may be ionized.

Examples of the ligand of the metal complex include the ligands exemplified for quantum dot 35. That is, the ligand of the metal complex may include a hydrocarbon compound. In the ligand of the metal complex, the hydrocarbon compound may contain a heterocyclic ring. The heterocyclic ring includes, for example, at least one selected from the group consisting of a phenanthroline ring and a thiophene ring. The hydrocarbon compound includes, for example, at least one selected from the group consisting of 1,10-phenanthroline and 4,4,4-trifluoro-1-(2-thienyl)-1,3-butanedione. The metal complex is, for example, (1,10-phenanthroline)tris[4,4,4-trifluoro-1-(2-thienyl)-1,3-butanedionato]europium(III) (Eu(TTA)₃phen).

The inorganic fluorescent substance may be another fluorescent substance different from the fluorescent substance containing quantum dot 35 and the fluorescent substance containing the metal complex. The inorganic fluorescent substance may be a fluorescent substance containing an inorganic particle. The fluorescent substance containing an inorganic particle is formed of, for example, one inorganic particle. A material for the inorganic particle include, for example, at least one selected from the group consisting of Y₃Al₅O₁₂:Ce (YAG), Y₃(Al,Ga)₅O₁₂:Ce (GYAG), Lu₃Al₅O₁₂:Ce(LuAG), (Si,Al)₆(O,N)₈:Eu(B-SiAlON), (La,Y)₃Si₆N₁₁:Ce(LYSN), LagSi₆N₁₁:Ce(LSN), Lu₂CaMg₂Si₃O₁₂:Ce(LCMS), Sr₂SiO₄:Eu, (Ba,Sr)Si₂O₂N₂:Eu, Ca₃Sc₂SiO₃O₁₂:Cₑ, CaSi₂O₂N₂:Eu, CaAlSiN₃:Eu(CASN), and (Ca,Sr)AlSiN₃:Eu(SCASN).

The inorganic particles have an average particle size ranging, for example, from 10 nm to 500 nm. The average particle size of the inorganic particles can be measured by the same method as for the average particle size of quantum dots 35. A shape of the inorganic particle may be spherical, scaly, or fibrous. The inorganic particles having an average particle size smaller than a wavelength of visible light suppress scattering of the visible light. Therefore, transparent wavelength conversion member 100 can be provided.

The organic fluorescent substance includes, for example, at least one selected from the group consisting of a condensed-ring compound and a derivative of the condensed-ring compound. The condensed-ring compound includes, for example, at least one selected from the group consisting of anthracene, phenanthrene, pentacene, tetracene, pyrene, perylene, benzopyrene, and coronene. The organic fluorescent substance is, for example, tetracene.

The organic fluorescent substance may include, for example, at least one selected from the group consisting of a rhodamine derivative, a coumarin derivative, a quinacridone derivative, a benzoxazole derivative, an arylamine derivative, a distyrylpyrazine derivative, a carbazole derivative, a silole derivative, a triphenylamine derivative, a naphthalimide derivative, a trifuranylamine derivative, a pyrazoloquinoline derivative, a hydrazone derivative, a pyridine derivative, a fluorene derivative, a benzoxazinone derivative, a phenanthroline derivative, a quinazolinone derivative, a quinophthalone derivative, a perinone derivative, a rubrene derivative, a styryl derivative, a thiophene derivative, an azole derivative, a pyrazole derivative, and a pyrrole derivative. The styryl derivative includes, for example, at least one selected from the group consisting of distyrylbenzene derivative, a distyrylarylene derivative, and a stilbene derivative. The thiophene derivative includes, for example, an oligothiophene derivative. The azole derivative includes, for example, at least one selected from the group consisting of an oxadiazole derivative, an oxazole derivative, a triazole derivative, and a benzoazatriazole derivative. The pyrazole derivative includes, for example, a pyrazoline derivative. The pyrrole derivative includes, for example, at least one selected from the group consisting of a porphyrin derivative and a phthalocyanine derivative. The organic fluorescent substance may include at least one selected from the group consisting of a spiro compound, a phenylene compound, and a diene compound. The diene compound includes, for example, at least one selected from the group consisting of a cyclopentadiene derivative and a tetraphenylbutadiene derivative.

Light emission characteristics of the organic fluorescent substance can be easily adjusted by changing a molecular structure of the organic fluorescent substance. When a plurality of organic fluorescent substances having different molecular structures are present in wavelength conversion member 100, wavelength conversion member 100 is capable of giving light having excellent color rendering properties.

A material for first matrix 25 is not particularly limited. First matrix 25 includes, for example, at least one selected from the group consisting of a resin and glass. Such a matrix suppresses the deactivation of fluorescent substance 30. That is, fluorescent substance 30 in wavelength conversion particle 21 is stabilized. The resin is not particularly limited as long as the resin is transparent. The resin includes, for example, at least one selected from the group consisting of a silicone resin and an acrylic resin. The silicone resin includes, for example, polysilsesquioxane. The acrylic resin includes, for example, polymethyl methacrylate (PMMA). First matrix 25 may include the resin or the glass as a main component. The "main component" means a component contained most in first matrix 25 by weight ratio. First matrix 25 may be substantially formed of the resin or the glass. The phrase "substantially formed of" means removal of another component that changes natural characteristics of the materials referred to. First matrix 25, however, may include impurities in addition to the resin or the glass.

First matrix 25 has a thermal conductivity lower than a thermal conductivity of second matrix 26. First matrix 25 has a thermal conductivity ranging, for example, from 0.1 W/(m·K) to 2.0 W/(m·K). The thermal conductivity of first matrix 25 can be measured with a test piece having a same composition as a composition of first matrix 25. The thermal conductivity can be measured by a method stipulated in Japanese Industrial Standards (JIS) R1611 (2010). The thermal conductivity is a value at 25°C.

Wavelength conversion particles 21 have an average particle size ranging, for example, from 0.01 µm to 50 µm. Wavelength conversion particles 21 may have an average particle size ranging from 0.01 µm to 10 µm, inclusive or from 0.1 µm to 10 µm, inclusive. The average particle size of wavelength conversion particles 21 can be determined by, for example, a following method. First, a section of wavelength conversion member 100 is observed with a scanning electron microscope. In an obtained electron microscopic image, an area of specific wavelength conversion particle 21 is calculated by image processing. A diameter of a circle having a same area as the calculated area is regarded as a particle size (particle diameter) of specific wavelength conversion particle 21. Particle sizes of a certain number of wavelength conversion particles 21 (for example, 50 particles) are each calculated and an average value of the calculated values is regarded as the average particle size of wavelength conversion particles 21. In the present disclosure, a shape of wavelength conversion particle 21 is not limited. The shape of wavelength conversion particle 21 may be spherical, scaly, or fibrous.

Second matrix 26 is formed of, for example, an inorganic material. The inorganic material includes, for example, at least one selected from the group consisting of Al₂O₃, ZnO, and SiO₂. The inorganic material may be crystalline. That is, second matrix 26 may include an inorganic crystal. Second matrix 26 desirably has translucency to the excitation light and the light emitted from fluorescent substance 30. From viewpoints of transparency and thermal conductive properties, ZnO is suitable as a material for second matrix 26. Use of ZnO as the material for second matrix 26 enables easy release of heat of wavelength conversion layer 20 to an exterior (mainly to substrate 10). Second matrix 26 may include ZnO as a main component. Second matrix 26 may be substantially formed of ZnO. Second matrix 26, however, may include impurities in addition to ZnO.

The inorganic crystal included in second matrix 26 is, for example, a zinc oxide (ZnO) crystal. The inorganic crystal is in detail a ZnO monocrystal or a ZnO polycrystal. ZnO has a wurtzite crystal structure. When second matrix 26 is formed through crystal growth, second matrix 26 has, for example, a crystal structure corresponding to a crystal structure of thin film 12. That is, when a ZnO polycrystal in a c-axis orientation is used as thin film 12, second matrix 26 includes a ZnO polycrystal in the c-axis orientation. The "ZnO in the c-axis orientation" means ZnO having a c-plane as a plane in parallel with a main plane (plane having a largest area) of substrate 10. Second matrix 26 including the ZnO polycrystal in the c-axis orientation suppresses light scattering in wavelength conversion layer 20, so that high optical output is achieved.

The ZnO polycrystal in the c-axis orientation contains a plurality of columnar crystal grains in the c-axis orientation. The ZnO polycrystal in the c-axis orientation has less grain boundaries along the c-axis. The "columnar crystal grains in the c-axis orientation" mean that growth of ZnO along the c-axis is faster than growth of ZnO along an a-axis to allow formation of vertically long ZnO crystal grains on substrate 10. The c-axes of ZnO crystal grains are in parallel with a normal line of substrate 10. Whether ZnO is a crystal in the c-axis orientation can be confirmed by X-ray diffraction (XRD) measurement (2θ/ω scan). As regards ZnO diffraction peaks obtained from a result of the XRD measurement, when a diffraction peak attributed to the c-plane of ZnO has an intensity higher than a diffraction peak attributed to a plane other than the c-plane of ZnO, ZnO can be determined to be a crystal in the c-axis orientation.

Second matrix 26 has a thermal conductivity higher than the thermal conductivity of first matrix 25. Second matrix 26 has a thermal conductivity ranging, for example, from 5.0 W/(m·K) to 50 W/(m·K). The thermal conductivity of second matrix 26 can be measured by the same method as for the thermal conductivity of first matrix 25.

Wavelength conversion layer 20 may further include filler particles. Wavelength conversion layer 20 includes the filler particles dispersed in second matrix 26. The filler particles irradiated with the excitation light emit no light of fluorescence or emit only light of fluorescence having an ignorable intensity. A material, a shape, and an addition amount of the filler particles are appropriately adjusted according to chromaticity required.

The filler particles include, for example, a metal oxide. The filler particles may be substantially formed of the metal oxide. Many metal oxides are chemically stable and hardly emit fluorescence to be suitable as the material for the filler particles. In one example, the filler particles include at least one selected from the group consisting of Al₂O₃ particles, SiO₂ particles, and TiO₂ particles.

The filler particles have an average particle size ranging, for example, from 0.1µm to 20 µm. The filler particles have an average particle size smaller than, for example, the average particle size of wavelength conversion particles 21. A ratio of an average particle size D2 of the filler particles to an average particle size D1 of wavelength conversion particles 21 (D2/D1) ranges, for example, from 0.01 to 0.90. The average particle size of the filler particles can be measured by the same method as for the average particle size of wavelength conversion particles 21. The shape of the filler particles may be spherical, scaly, or fibrous. A volume of wavelength conversion particles 21 is defined as V1. A volume of the filler particles is defined as V2. With these definitions, a value of a proportion V2/(V1 + V2) ranges, for example, from 0.1 to 0.9.

Next, a method for manufacturing wavelength conversion member 100 is described.

First, wavelength conversion particles 21 are prepared. As wavelength conversion particles 21, commercially available particles may be used. When first matrix 25 includes a resin, wavelength conversion particles 21 can be produced by a following method. First, a dispersion liquid containing a resin and fluorescent substance 30 is prepared. A solvent contained in the dispersion liquid is removed to give a solid. The solid is pulverized to give wavelength conversion particles 21.

When first matrix 25 includes glass, wavelength conversion particles 21 can be produced by a following method. First, a sol is prepared that contains a precursor such as silicon alkoxide. Fluorescent substance 30 is dispersed in the sol. The sol is made into a gel and fired. An obtained solid is pulverized to give wavelength conversion particles 21.

Next, substrate 10 is prepared. For example, a crystalline ZnO thin film is formed as thin film 12 on substrate main body 11. Used as a method for forming the ZnO thin film is vapor phase film formation such as vapor deposition, electron beam evaporation, reactive plasma deposition, ion assisted deposition, sputtering, or pulsed laser deposition. Thin film 12 may also be formed by a following method. First, a sol is prepared that contains a precursor such as zinc alkoxide. The sol is applied to substrate main body 11 by printing to form a coating. Next, the coating is heat-treated to give thin film 12. Thin film 12 is a ZnO monocrystalline thin film or a ZnO polycrystalline thin film.

Next, a layer containing wavelength conversion particles 21 is formed on substrate 10 (on thin film 12). For example, a dispersion liquid containing wavelength conversion particles 21 is prepared. Substrate 10 is disposed in the dispersion liquid and wavelength conversion particles 21 are deposited on substrate 10 by electrophoresis. These procedures are capable of forming, on substrate 10, the layer containing wavelength conversion particles 21. The layer containing wavelength conversion particles 21 can also be formed on substrate 10 by disposing substrate 10 in the dispersion liquid to let wavelength conversion particles 21 to settle out on the substrate. The layer containing wavelength conversion particles 21 can also be formed on substrate 10 by thin-film formation such as printing, with an application liquid containing wavelength conversion particles 21.

Next, second matrix 26 is formed among the plurality of wavelength conversion particles 21. As a method for forming second matrix 26, solution growth is usable with a solution containing a Zn ion. As the solution growth, used is, for example, chemical bath deposition performed at atmospheric pressure, hydrothermal synthesis performed at pressure higher than or equal to atmospheric pressure, or electrochemical deposition in which a voltage or a current is applied. As a solution for crystal growth, for example, an aqueous zinc nitrate solution containing hexamethylenetetramine is used. Crystalline second matrix 26 is grown epitaxially on thin film 12. This growth gives wavelength conversion layer 20.

The solution for crystal grown typically shows acidity. Therefore, fluorescent substance 30 that is brought into contact with the solution for crystal growth is sometimes oxidized and thus deactivated. When fluorescent substance 30 is a fluorescent substance containing quantum dot 35, bringing fluorescent substance 30 into contact with the solution for crystal grown sometimes aggregate quantum dots 35. In the manufacturing method according to the present exemplary embodiment, fluorescent substance 30 is surrounded by first matrix 25. Therefore, fluorescent substance 30 is no direct contact with the solution for crystal growth. This no direct contact of fluorescent substance 30 with the solution suppresses the deactivation of fluorescent substance 30 and the aggregation of quantum dots 35 That is, wavelength conversion member 100 having aimed optical characteristics can easily be provided.

In wavelength conversion member 100, second matrix 26 has a thermal conductivity higher than a thermal conductivity of first matrix 25. Therefore, wavelength conversion member 100 has excellent heat dissipation properties. Wavelength conversion member 100 is capable of suppressing a great rise in temperature of fluorescent substance 30. This suppression enables fluorescent substance 30 to maintain light emission efficiency. When fluorescent substance 30 is a fluorescent substance containing quantum dot 35, burning off of a ligand coordinated with quantum dot 35 is suppressed. This suppression enables quantum dots 35 to easily maintain dispersibility.

### (Modified example of wavelength conversion particles)

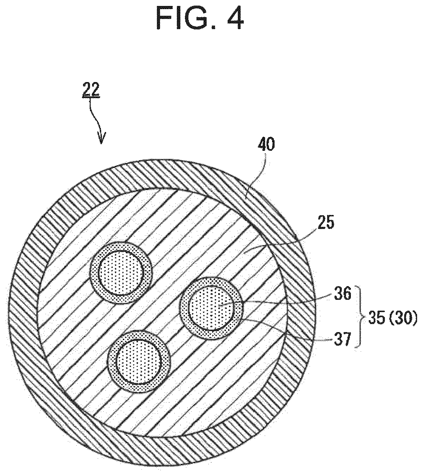

As illustrated in FIG. 4, wavelength conversion particle 22 of a modified example further includes protective layer 40. In wavelength conversion particle 22, fluorescent substance 30 is formed of one quantum dot 35. Wavelength conversion particle 22 has a same structure as a structure of wavelength conversion particle 21 except that wavelength conversion particle 22 includes protective layer 40 and fluorescent substance 30 is formed of one quantum dot 35.

Protective layer 40 covers first matrix 25. In detail, protective layer 40 covers an entire surface of first matrix 25. Protective layer 40 may only partially cover the surface of first matrix 25. Protective layer 40 includes, for example, a resin. As the resin, the resins described above are usable. Protective layer 40 includes, for example, polysilsesquioxane. Protective layer 40 may include the resin as a main component. Protective layer 40 may be substantially formed of the resin. Protective layer 40 has a composition different from a composition of first matrix 25.

Protective layer 40 has an average thickness ranging, for example, from 10 nm to 500 nm. A thickness of protective layer 40 means a thickness from a surface of protective layer 40 to the surface of first matrix 25. The average thickness of protective layer 40 can be determined by, for example, an electron microscopic observation image of a section of wavelength conversion particle 22 and energy dispersive X-ray spectrometry (EDX). For example, the thickness of protective layer 40 is measured at a plurality of any points (for example, 5 points) in an EDX image of a specific particle. An average value of the obtained values can be regarded as the thickness of protective layer 40 of the specific particle. The same measurement is further performed on a plurality of particles (for example, 10 particles). An obtained total thickness value can be divided by the number of particles (10 particles) to calculate the average thickness of protective layer 40. The section of wavelength conversion particle 22 can be exposed by, for example, a focused ion beam (FIB) method.

Wavelength conversion particles 22 can be produced by a following method. First, precursor particles are prepared. A precursor particle includes fluorescent substance 30 surrounded by first matrix 25. The precursor particles can be produced by the same method as the method for producing wavelength conversion particles 21. Next, a dispersion liquid containing a resin is prepared. The precursor particles are added to the dispersion liquid, and the dispersion liquid is stirred. The precursor particles are extracted from the dispersion liquid. The precursor particles are dried to form protective layer 40 on surfaces of the precursor particles. These procedures give wavelength conversion particles 22.

Fluorescent substance 30 is sometimes deactivated by being brought into contact with a gas such as oxygen, a corrosive gas, or water vapor. In the present exemplary embodiment, wavelength conversion particle 22 includes protective layer 40. Therefore, the gas cannot easily pass through first matrix 25. That is, protective layer 40 is capable of suppressing the deactivation of fluorescent substance 30. The deactivation of fluorescent substance 30 is suppressed to enable fluorescent substance 30 to easily maintain the light emission characteristics.

### (Exemplary embodiments of light source)

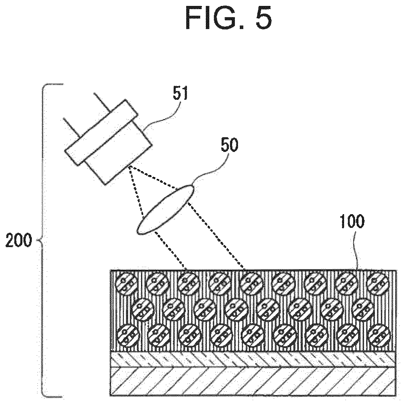

As illustrated in FIG. 5, light source 200 according to the present exemplary embodiment includes wavelength conversion member 100 and light-emitting element 51. Light-emitting element 51 emits excitation light. Wavelength conversion member 100 is disposed on an optical path of the excitation light emitted from light-emitting element 51. Wavelength conversion layer 20 of wavelength conversion member 100 is positioned between light-emitting element 51 and substrate 10 of wavelength conversion member 100. Light source 200 is a reflection-type light source.

Light-emitting element 51 is typically a semiconductor light-emitting element. Examples of the semiconductor light-emitting element include a light emitting diode (LED), a superluminescent diode (SLD), and a laser diode (LD).

Light-emitting element 51 may be formed of one LD or a plurality LDs. The plurality of LDs may be optically coupled with each other. Light-emitting element 51 emits, for example, blue-violet light. In the present disclosure, the blue-violet light is light having a peak wavelength ranging from 380 nm to 420 nm.

Light source 200 further includes optical system 50. Optical system 50 may be positioned on the optical path of the excitation light emitted from light-emitting element 51. Optical system 50 includes optical components such as a lens, a mirror, and an optical fiber.

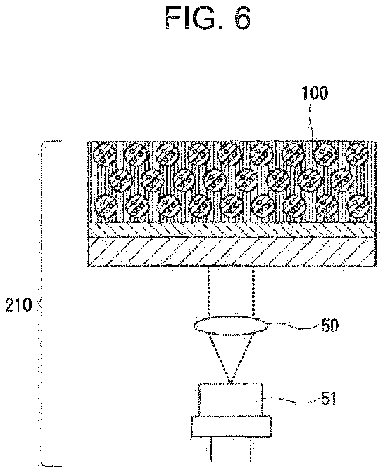

As illustrated in FIG. 6, light source 210 according to the present exemplary embodiment includes wavelength conversion member 100 and light-emitting element 51. Light-emitting element 51 faces substrate 10 of wavelength conversion member 100. Light from light-emitting element 51 passes through substrate 10 and reaches wavelength conversion layer 20. Light source 210 is a transmission-type light source.

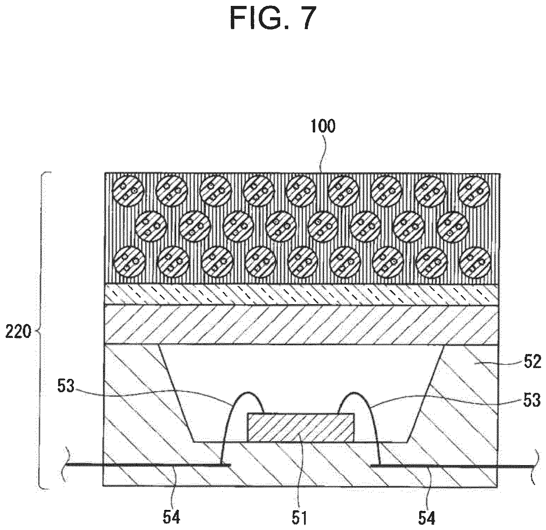

As illustrated in FIG. 7, light source 220 according to the present exemplary embodiment includes wavelength conversion member 100, light-emitting element 51, housing 52, bonding wire 53, and terminal 54. Wavelength conversion member 100 is attached to housing 52. In light source 220, light-emitting element 51 is an LED. Light-emitting element 51 is disposed in housing 52. Light-emitting element 51 faces substrate 10 of wavelength conversion member 100. Light from light-emitting element 51 passes through substrate 10 and reaches wavelength conversion layer 20. Light source 220 is a transmission-type light source.

A part of terminal 54 is embedded in housing 52. Terminal 54 is electrically connected to a power source (not shown). Bonding wire 53 electrically connects light-emitting element 51 to terminal 54. Light source 220 is suitable as a backlight of a liquid crystal display device.

### (Exemplary embodiment of lighting device)

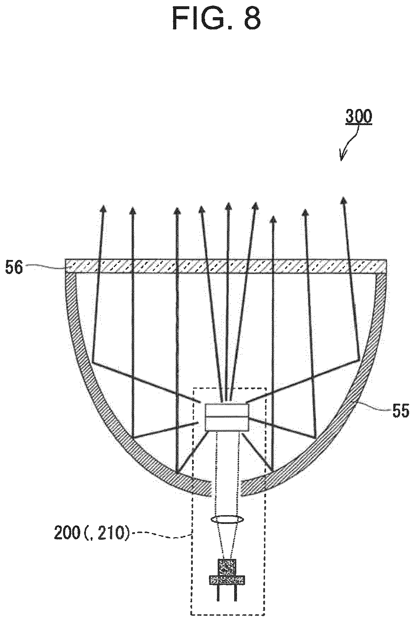

As illustrated in FIG. 8, lighting device 300 according to the present exemplary embodiment includes light source 200 and optical component 55. Light source 210 described with reference to FIG. 6 is also usable in place of light source 200. Optical component 55 is a component for guiding light emitted from light source 200 forward, and is specifically a reflector. Optical component 55 includes, for example, a metal film of Al, Ag, or the like, or an Al film on a surface of which a protective film is formed. Filter 56 may be provided forward of light source 200. In order not to allow coherent blue light from the light-emitting element of light source 200 to directly come out, filter 56 absorbs or scatters the blue light. Lighting device 300 may be a so-called reflector-type or projector-type lighting device. Lighting device 300 is, for example, a vehicle headlamp.

### INDUSTRIAL APPLICABILITY

The wavelength conversion member according to the present disclosure is usable in, for example, a general lighting device such as a ceiling light. The wavelength conversion member according to the present disclosure is also usable in, for example, a light source of a special lighting device such as a spotlight, a stadium light, or a studio light. The wavelength conversion member according to the present disclosure is also usable in, for example, a light source of a vehicle lighting device such as a headlamp. The wavelength conversion member according to the present disclosure is also usable in, for example, a light source of projection equipment such as a projector or a head-up display. The wavelength conversion member according to the present disclosure is also usable in, for example, a medical or industrial endoscope light; or a light source of an imaging device such as a digital camera, a mobile phone, or a smartphone. The wavelength conversion member according to the present disclosure is also usable in, for example, a light source of a liquid crystal display device such as a personal computer (PC) monitor, a laptop personal computer, a television, a personal digital assistant (PDA), a smartphone, a tablet PC, or a mobile phone As described above, the wavelength conversion member and the light source according to the present disclosure are industrially useful.

### REFERENCE MARKS IN THE DRAWINGS

10: substrate
11: substrate main body
12: thin film
20: wavelength conversion layer
21, 22: wavelength conversion particle
25: first matrix
26: second matrix
30: fluorescent substance
35: quantum dot
36: core
37: shell
40: protective layer
51: light-emitting element
55: optical component
100: wavelength conversion member
200, 210, 220: light source
300: lighting device

## Claims

1. A wavelength conversion member comprising:
wavelength conversion particles each including a fluorescent substance and a first matrix surrounding the fluorescent substance; and
a second matrix having a thermal conductivity higher than a thermal conductivity of the first matrix and surrounding the wavelength conversion particles.

2. The wavelength conversion member according to claim 1, wherein the fluorescent substance is at least one selected from a group consisting of a fluorescent substance containing a quantum dot, a fluorescent substance containing a metal complex, and an organic fluorescent substance.

3. The wavelength conversion member according to claim 1 or 2, wherein the first matrix includes at least one selected from a group consisting of a resin and glass.

4. The wavelength conversion member according to any one of claims 1 to 3, wherein the second matrix includes an inorganic crystal.

5. The wavelength conversion member according to claim 4, wherein the inorganic crystal is a zinc oxide crystal.

6. The wavelength conversion member according to claim 5, wherein the zinc oxide crystal is a zinc oxide polycrystal in a c-axis orientation.

7. The wavelength conversion member according to any one of claims 1 to 6, wherein the wavelength conversion particles have an average particle size ranging from 0.1 µm to 10 µm, inclusive.

8. The wavelength conversion member according to any one of claims 1 to 7, wherein the wavelength conversion particles each further include a protective layer covering the first matrix.

9. A light source comprising:
a light-emitting element; and
the wavelength conversion member according to any one of claims 1 to 8, the wavelength conversion member being disposed on an optical path of light emitted from the light-emitting element.
